# EUROPÄISCHE PATENTANMELDUNG

(11) **EP 2 871 771 A1**
(43) Veröffentlichungstag der Anmeldung: **13.05.2015**
(21) Anmeldenummer: 14020077.5
(22) Anmeldetag: 08.11.2014
(51) Int. Cl.: H02S 30/10, H01L 31/05, H02S 40/36

(54) **PV-Modul bei dem Brüche von Zellen vermieden werden und dessen Anwendung in PV-Kraftwerken**

(30) Priorität: 08.11.2013 DE 102013018754
(71) Anmelder: Naebauer, Anton, 80805 München (DE); Gehrlicher, Klaus, 85540 Haar (DE)
(72) Erfinder: Naebauer, Anton, 80805 München (DE); Gehrlicher, Klaus, 85540 Haar (DE)

(57) **Zusammenfassung**

PV-Modul mit kristallinen Zellen mit Busbars, wobei der mechanische Stress, der zu Microcracks in den Zellen führen kann möglichst vermieden wird durch aussteifende Strukturen, die auf der Rückseite des Moduls angebracht sind, und die senkrecht zu den Busbars der Zellen verlaufen

## Beschreibung

Im Laufe der Betriebszeit von Photovoltaik-Modulen kommt es zu einer Degradation unter anderem des Wirkungsgrades der Photovoltaik-Module.
Zum Teil sind die Ursachen und Wirkungsmechanismen der Degradation bekannt, so dass gezielt Gegenmaßnahmen eingeleitet werden können. In vielen Fällen sind die Effekte aber noch weitgehend unerforscht. Zu den bekannten Phänomenen zählen zum Beispiel bei kristallinen Silizium PV-Modulen die "Microcracks" bei denen es zu Rissen in den Zellen und den elektrischen Kontaktfingern kommt, wodurch dann die betroffenen Zellbereiche mehr oder weniger "inaktiv" werden können. Ursachen sind hier hauptsächlich jegliche mechanische Spannungen in den Zellen sowohl während der Zell- bzw. Modul-Produktion, während des Transports und auch während des Betriebs des PV-Moduls sein.

In diesem Zusammenhang soll auch das Phänomen der Schneckenspuren (eine Verfärbung der leitenden Kontaktfinger auf der Zelloberfläche) erwähnt werden, deren Ursachen noch nicht vollständig erforscht sind, die jedoch bevorzugt in Verbindung mit Mikrorissen auftreten, und bei deren Entstehung möglicherweise auch elektrochemische Reaktionen auftreten können.

Der Erfindung liegt die Aufgabe zu Grunde, ein kostengünstiges PV-Modul mit kristallinen Zellen herzustellen, bei dem der mechanische Stress, der zu Microcracks in den Zellen führen kann möglichst vermieden wird. Dies wird erfindungsgemäß dadurch gelöst, dass auf das Modul auf der Rückseite versteifende Strukturen aufgebracht sind, die senkrecht zu den Busbars der Zellen verlaufen.

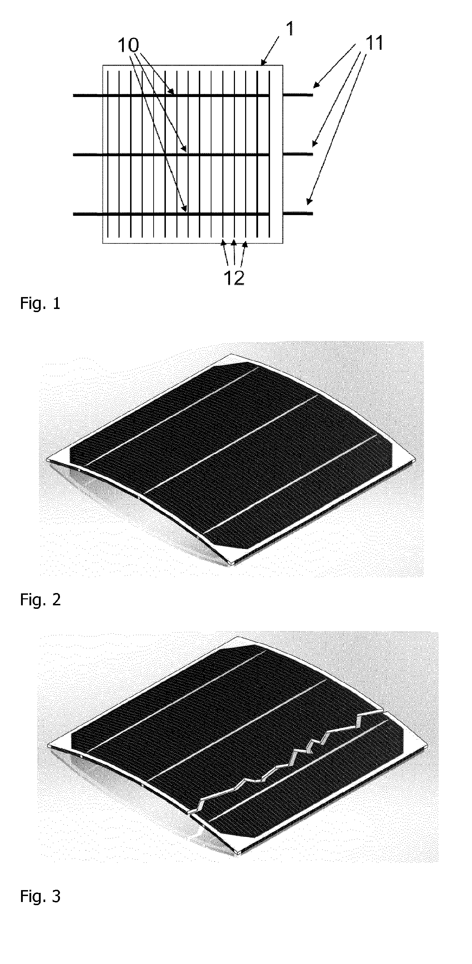

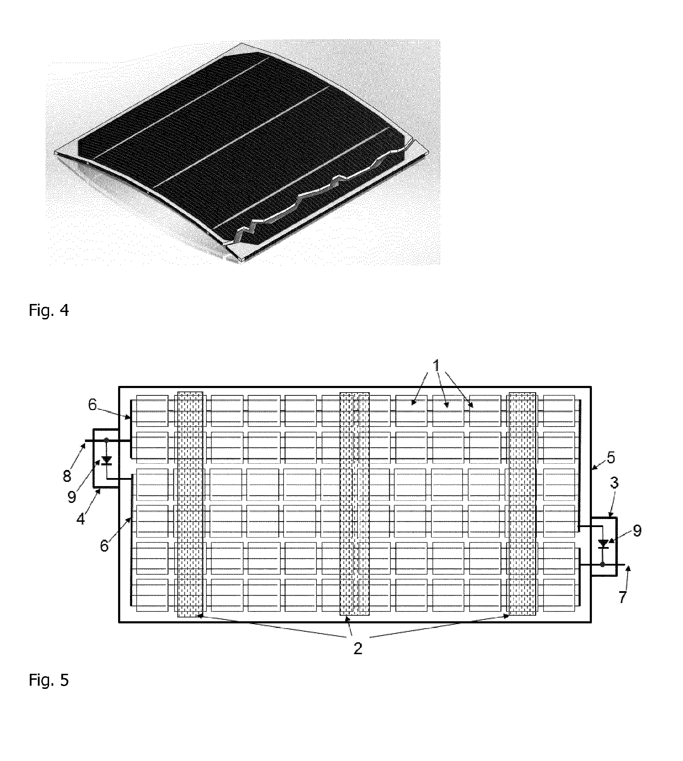

Es ist bekannt, dass PV-Zellen durch mechanischen Stress degradieren. Es hat sich gezeigt, dass die Zellen bei unterschiedlichem mechanischen Stress unterschiedlich und unterschiedlich leicht brechen, und dass ein Bruch - abhängig von der Lage des Bruchs unterschiedlich starke Leistungsdegradationen der Zelle hervorrufen kann. Kristalline Solarzellen in Modulen werden sowohl bei der Produktion, als auch beim Transport, bei der Montage und auch im Betrieb (Umweltlasten; Wind, Schnee, ...) mechanisch gestresst, wodurch es zu Brüchen der Zellen kommen kann. In Abhängigkeit vom Verlauf der Bruchlinien relativ zu den Busbars (parallel oder senkrecht) sind die Auswirkungen, eines Bruchs unterschiedlich schwerwiegend. Bei einem Bruch mit einer Bruchlinie im Bereich außerhalb der Busbars wird in der Regel, der Zellbereich außerhalb der Bruchlinie elektrisch von der Zelle abgetrennt, und es kommt zu einem deutlichen - der Größe des abgetrennten Bereichs proportionalem Leistungsverlust der Zelle (siehe Fig. 4).
Bei einem Bruch mit Bruchlinie zwischen zwei Busbars einer Zelle wird in der Regel kein Zellbereich elektrisch abgetrennt, und es ist nicht mit deutlichem Leistungsverlust zu rechnen (siehe Fig. 3). Bei einem Zellbruch bei dem die Bruchlinie im Wesentlichen senkrecht zu den Busbars verläuft, wird in der Regel der Stromfluss durch die Metallbänder, die die Busbars verstärken aufrechterhalten, so dass auch hier kein großer Leistungsabfall zu erwarten ist.
Wenn man die bei heutigen Modulen auftretenden Bruchlinien von Zellen kategorisieren würde in die Gruppen "im Wesentlichen parallel zu den Busbars" und "im Wesentlichen senkrecht zu den Busbars", dann findet man, dass bei den heute üblichen gerahmten Modulen deutlich mehr Bruchlinien parallel zu den Busbars, als senkrecht zu den Busbars auftreten.
Die Ursache dafür kann zum einen darin liegen, dass die Zellen in dieser Richtung leichter brechen, zum anderen darin liegen, dass gegeben durch den typischen Aufbau gerahmter kristalliner Solarmodule die Zellen so gestresst werden, dass die Zellen in der Richtung parallel zu den Busbars leichter brechen.
Es wurde gefunden, dass die Degradation der Modulperformance durch Zellbrüche in einem Modul deutlich reduziert werden kann, wenn eine Krümmung der Solarmodule um eine parallel zu den Busbars verlaufende Krümmungsachse verhindert wird. Dies kann geschehen, durch Strukturen die das Solarmodul aussteifen, und die im Wesentlichen senkrecht zu den Busbars verlaufen. Damit kann die üblicherweise dominate Zahl der Brüche parallel zu den Busbars, die die Modulperformance besonders stark degradieren, deutlich reduziert werden.
Dies kann beispielsweise dadurch geschehen, dass Strukturen zur Aussteifung des Modul-Laminats, die auf der Rückseite des Moduls angebracht sind.
Besonders vorteilhaft ist es, wenn diese aussteifenden Strukturen gleichzeitig so ausgebildet sind, dass das Solarmodul damit an einer Unterkonstruktion befestigt werden kann (derartige Befestigungsstrukturen sind auch unter der Bezeichnung "Backraits" bekannt).
Backrails haben bisher in erster Linie Halterungs-Funktion und nicht die Aufgabe der Versteifung um Zellbrüche zu verhindern und werden heute vor allem bei großflächigen Dünnschicht-Modulen verwendet und nur in Ausnahmefällen (in der Regel zu Versuchszwecken) bei kristallinen PV-Modulen.
In dieser Schrift wird offengelegt, dass Backrails an den richtigen Stellen auf der Rückseite des Moduls positioniert und ausgerichtet am Modul eine Krümmung der Zellen derart verhindern, dass der bisher am häufigsten auftretende Zellbruch mit Brechungslinien parallel zu den Busbars weitgehend verhindert wird.
In einer Weiterbildung der Erfindung wird das erfindungsgemäße kristallines PV Modul dahingehend optimiert, dass bei einer typischen Anwendung in einem Freiflächen PV-Kraftwerk auch die Verdrahtung so gestaltet wird, dass elektrische Verluste reduziert werden und weniger Kabellänge benötigt wird.
In einer weiteren Weiterbildung der Erfindung werden in dem PV-Modul kristalline Zellen verwendet, die nicht mehr - wie heute üblich - quadratisch oder nahezu quadratisch sind sondern die rechteckig sind. Diese Zellen können hergestellt werden durch Teilen der heute üblichen Zellen in zwei oder drei gleich große Teil-Zellen, genannt Halb-Zellen oder Drittel-Zellen, wobei die Zellen senkrecht zu den Busbars abgeschnitten sind so dass die Busbars der geteilten Zellen parallel zu den kurzen Seiten des Rechtecks liegen. Aufgrund der halben bzw. drittel Zellfläche ist der Strom durch die Teil-Zellen auch nur die Hälfte bzw. ein Drittel der ganzen Zelle. Da die Busbars der Teil-Zellen parallel zu den kurzen Seiten der typischerweise rechteckigen Zelle verlaufen, ist auch der Strom in den einzelnen Busbars der Teil-Zelle nur ein Bruchteil (beispielsweise die Hälfte bzw. ein Drittel) des Stromes einer gesamten Zelle (jeweils unter vergleichbaren Bestrahlungs- und Verschaltungsbedingungen). Wegen des geringeren Stroms kann der leitungsquerschnitt der Busbars der Teilzellen reduziert werden so dass durch die Busbars auch ein geringerer Teil der aktiven Zellfläche abgedeckt wird und dadurch der Wirkungsgrad der Zellen und des Moduls deutlich verbessert wird. Weiterhin werden optimierte Verschaltungen der Zellen innerhalb des Modul offenbart, mit denen die oben erwähnte optimierte Verdrahtung eines Freiflächen PV-Kraftwerks erreicht werden kann.

Im Folgenden wird die Erfindung beispielhaft anhand der beiliegenden Figuren erläutert. Es zeigen:
- Fig. 1:: Solarzelle mit 3 Busbars
- Fig. 2:: Solarzelle mit 3 Busbars gekrümmt mit Krümmungsachse parallel zu den Bus-Bars.
- Fig. 3:: Solarzelle mit 3 Busbars mit Krümmungsachse parallel zu den Bus-Bars mit Bruchlinie zwischen zwei Busbars einer Zelle.
- Fig. 4:: Solarzelle mit 3 Busbars mit Krümmungsachse parallel zu den Bus-Bars und mit Bruchlinie außerhalb des Bereichs der Busbars der Zelle
- Fig. 5:: Solarmodul bei dem die das Solarmodul aussteifenden Strukturen (2) senkrecht zu den Busbars der Zellen verlaufen und die Anschlussdosen auf der linken und der rechten Seite angebracht sind und bei dem 2 Zell-Strings parallel geschaltet sind.
- Fig. 6:: Übliche Meanderförmige elektrische Verschaltung in Verbindung mit horizontalen Busbars ermöglicht bei 6 seriell verschalteten Zellreihen nicht den optimalen Anschluss der Anschlussdosen an der rechten und linken Seite des Moduls
- Fig. 7:: Meanderförmige elektrische Verschaltung in Verbindung mit horizontalen busbars ermöglicht bei 5 seriell verschalteten Zellreihen den vorteilhaften Anschluss von J-Boxen an der rechten und linken Seite des Moduls
- Fig. 8:: Vorteilhafte Verbindung mit kurzen Kabeln zwischen zwei benachbarten Modulen
- Fig. 9:: Vorteilhafte Verbindung mit kurzen Anschlussleitungen zwischen zwei benachbarten Modulen bei nicht horizontal verlaufenden Busbars
- Fig. 10:: Solarmodul mit Parallelschaltung von 2 Teilstrings von seriell verschalteten Zellen und Bypassdioden, die einen direkten Pfad zwischen Pluspol und Minuspol bilden.
- Fig. 11:: Stromfluss wenn das linke Modul bestrahlt wird und das rechte Modul nicht bestrahlt wird, wobei es über die Bypassdioden keinen direkten Strompfad zwischen Pluspol und Minuspol gibt.
- Fig. 12:: Stromfluss wenn das linke Modul bestrahlt wird und das rechte Modul nicht bestrahlt wird, wobei die Bypassdioden einen direkten Strompfad zwischen Pluspol und Minuspol bilden.
- Fig. 13:: Erste gebräuchliche Verschaltung am Beispiel von zwei Tischreihen
- Fig. 14:: Zweite gebräuchliche Verschaltung am Beispiel von zwei Tischreihen
- Fig. 15:: Vorteilhafte Verschaltung von zwei Tischreihen bei der auch Module mit Bypassdioden verwendet werden können, bei denen die Bypassdioden keinen direkten Pfad zwischen Plus und Minuspol bilden (unverschattet).
- Fig. 16:: Vorteilhafte Verschaltung von zwei Tischreihen bei der auch Module mit Bypassdioden verwendet werden können, bei denen die Bypassdioden keinen direkten Pfad zwischen Plus und Minuspol bilden (teilweise verschattet).
- Fig. 17:: Solarmodul optimiert in Bezug auf Verschattungsperformance mit Parallelschaltung von 2 Zellen-Strings und Bypassdioden, die keinen direkten Pfad zwischen Pluspol und Minuspol bilden.
- Fig. 18:: Solarmodul mit zwei parallel geschalteten Strings mit jeweils 5 Zellreihen
- Fig. 19:: Solarmodul mit drei parallel geschalteten Strings mit jeweils 3 Zellreihen
- Fig. 20:: Halb-Zelle (links) und Drittel-Zelle (rechts) jeweils mit Busbars
- Fig. 21:: Beispiel für vorteilhafte Anordnungen der Anschlussdosen am Modul im Bereich des linken und rechten Randes wobei die Dosen vollständig innerhalb der Modulränder liegen.
- Fig. 22:: Beispiel für vorteilhafte Anordnungen der Anschlussdosen am Modul im Bereich des linken und rechten Randes wobei die Dosen teilweise über den Modulrand hinausragen.
- Fig. 23:: Beispiel für vorteilhafte Anordnungen der Anschlussdosen am Modul im Bereich des linken und rechten Randes wobei eine der Dosen im Bereich der Ecke liegt.
- Fig. 24:: Beispiel für vorteilhafte Anordnungen der Anschlussdosen am Modul wobei das Rückglas eine geringere Links-Rechts Ausdehnung aufweist als das Frontglas
- Fig. 25:: Beispiel für vorteilhafte Anordnungen der Anschlussdosen am Modul, wobei die beiden Anschlussdosen in diagonal gegenüberliegenden Ecken angebracht sind.
- Fig. 26:: Modul aus Halb-Zellen (51) aufgebaut wobei 6 Teil-Strings parallel geschaltet sind
- Fig. 27:: Modul aus Halb-Zellen (51) aufgebaut wobei 2 Teil-Strings parallel geschaltet sind
- Fig. 28:: Modul mit geklebten Backrails und Anschlussdosen links und rechts
- Fig. 29:: Platzsparende Anordnung von zwei Modulen Rückseite an Rückseite für Lagerung und Transport der Module
- Fig. 30:: Doppelmodul mit 4 elektrischen Anschlüssen wobei ein Teilmodul links den Pluspol und rechts den Minuspol hat und das zweite Teilmodul den Pluspol rechts und den Minuspol links hat.

### Bezugszeichenliste:

- 1: Solarzelle
- 2: aussteifende Struktur auf Rückseite des PV-Moduls
- 3: J-Box (Anschlussdose) für Plus-Anschluss des PV-Moduls
- 4: J-Box (Anschlussdose) für Minus-Anschluss des PV-Moduls
- 5: Solarmodul
- 6: leitfähiges Bändchen für elektrischen Verbindungen innerhalb des PV-Moduls
- 7: Plus-Anschluss des PV-Moduls
- 8: Minus-Anschluss des PV-Moduls
- 9: Bypassdiode
- 10: Busbar auf der Vorderseite
- 11: Verlängerung der Anschlussstreifen für die Rückseite
- 12: Kontaktfinger
- 13: Verbindung zwischen benachbarten Modulen
- 14: Solarzelle (Schaltzeichen)
- 21: Abgriff für Bypassdiode nach 12 seriell verschalteten Zellen (gezählt vom Minuspol)
- 22: Abgriff für Bypassdiode nach 24 seriell verschalteten Zellen (gezählt vom Minuspol)
- 23: Abgriff für Bypassdiode nach 18 seriell verschalteten Zellen (gezählt vom Minuspol)
- 24: Abgriff für Bypassdiode nach 25 seriell verschalteten Zellen (gezählt vom Minuspol)
- 25: Pfeil der Richtung des Stromflusses angibt
- 40: Elektrische Verbindung der Mittelabgriffe zweier Strings
- 41: zweite Tischreihe (steht in Richtung Sonne hinter der ersten Tischreihe)
- 42: erste Tischreihe (kann zweite Tischreihe verschatten)
- 43: PV-Modul
- 44: Sonne
- 45: Verschattungsgrenze
- 46: Elektrische Leitung zum Anschluss von Strings
- 47: Ausgang zum Stromabnehmer
- 48: Pfeil der Richtung von Stromfluss (z. B. in Modulzeile) angibt
- 51: Halb-Zelle mit Busbars
- 52: Drittel-Zelle mit Busbars
- 53: Mittelachse zwischen rechtem und linkem Rand des Moduls
- 54: linke Anschlussdose
- 55: verbotener Bereich für rechte Anschlussdose
- 56: rechte Anschlussdose
- 57: Rand des Rückglases
- 58: Rand des Frontglases
- 59: gekappte (fehlende) Ecke des Rückglases
- 60: Rückglas
- 61: PV-Modul
- 62: Klebstoff
- 63: Backrail

Figur 1 zeigt die Vorderansicht einer Solarzelle 1 mit 3 Busbars (10). Dies bedeutet, dass die Zelle 3 Busbars auf der Vorderseite besitzt und ebenso 3 Anschlussstreifen auf der Rückseite, deren Verlängerungen 11 in Figur 1 zu sehen sind. Die Busbars dienen dazu, den elektrischen Strom zu sammeln und abzuleiten. Auf der Vorderseite sind zudem die Kontaktfinger 12 zu sehen, die den elektrischen Strom "einsammeln", der in Folge der Bestrahlung des Halbleitermaterials mit Licht entsteht.

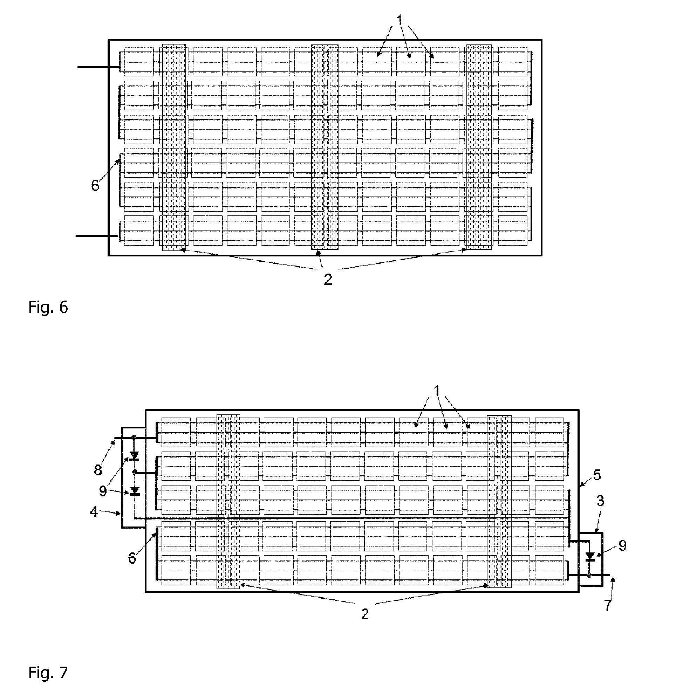

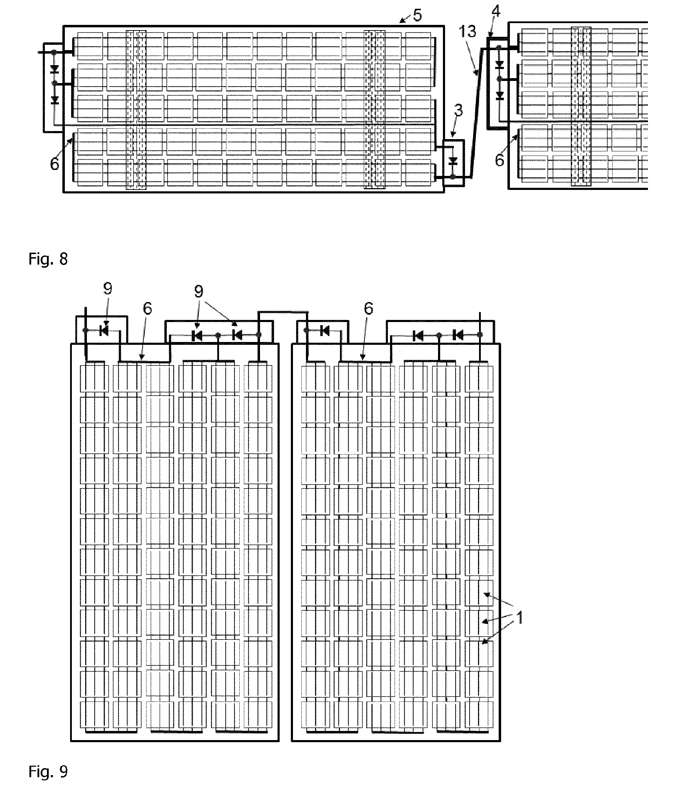

Bei den Zellen wird in dieser Schrift angenommen, dass der Plus-Pol auf der Rückseite und der Minuspol an der Vorderseite der kristallinen Zelle ist. Hierbei ist zu bemerken, dass für die in der Schrift offenbarten Erfindungen auch Zellen mit umgekehrter Polarität verwendet werden können, wobei ein Fachmann ermitteln kann, welche Modifikationen (z. B. umgepolte Bypass Dioden) bei geänderter Zellpolarität vorzunehmen sind.
Wird nun eine Zelle, wie in Fig. 2 gezeigt, um eine Krümmungsachse parallel zu den Busbars gekrümmt kann es sehr leicht zu einem Bruch kommen, der im Wesentlichen parallel zu den Busbars verläuft.
Figur 3 zeigt einen Bruch der zwischen zwei Busbars verläuft. Hierbei sind nach wie vor alle Bereiche der Zelle elektrisch an einen Busbar angekoppelt, wodurch die Degradation der gebrochenen Zelle nicht so stark ist, wie in Figur 4, wo die Bruchlinie außerhalb des Bereichs der Busbars verläuft, so dass der abgebrochene Zellbereich keine elektrische Verbindung mehr zu einem, den elektrischen Strom abführenden Busbar hat, und daher nicht mehr zur Stromerzeugung beitragen kann. Dies führt zu deutlichen Performance Verlusten der Solarzelle. Wenn die Krümmungsachse der Zelle nicht parallel, sondern senkrecht zu den Busbars verläuft brechen die Zellen erfahrungsgemäß seltener, gleichzeitig entstehen dadurch keine Zellbereiche, die nicht mehr an die Busbars angeschlossen sind.
Verlaufen in einer großen Freiflächen-Installation mit vielen Tischreihen die Busbars horizontal, dann kann man davon ausgehen, dass benachbarte, über die Busbars direkt verbundene Zellen die zu dem gleichen String gehören, gleichartig verschattet werden, da auch die Grenze des Schattens auf den Modulen horizontal verläuft. Sofern die Busbars nicht horizontal verlaufen, ist damit zu rechnen, dass innerhalb eines Strings die Zellen deutlich unterschiedlich bestrahlt sein können mit den bekannten negativen Auswirkungen auf die Ernte.
Daraus wird ersichtlich, dass Module mit horizontal verlaufenden Busbars in typischen Freiflächenanlagen Vorteile bezüglich der Performance bei Verschattung aufweisen.
Ein Modul, das die dargelegten Anforderungen erfüllt ist in Figur 5 gezeigt. Hier sind drei aussteifende Strukturen 2 (Backrails) auf der Rückseite des Solarmoduls senkrecht zu den Busbars angebracht sind. Statt drei aussteifenden Strukturen könnten es ebenso zwei oder vier oder eine an die Größe des Moduls angepasste Anzahl von aussteifenden Strukturen sein. Bezüglich des Abstandes der aussteifenden Strukturen voneinander und vom Modulrand hat sich bewährt, dass der Abstand vom parallel verlaufenden Modulrand 30 % ... 50 % des Abstands zweier parallel verlaufender aussteifender Strukturen beträgt.
Als weitere Besonderheit weist das in Fig. 5 gezeigte PV-Modul zwei Anschlussdosen (J-Box) auf, wobei die J-Box 3 für den Plus-Anschluss 7, und die J-Box 4 für den Minus-Anschluss 8 der Solarmoduls dient. In den Anschlussdosen sind gleichzeitig Bypassdioden untergebracht. Die Anschlussdosen sind links und rechts am Modul angebracht. Damit ist es möglich, dass mehrere nebeneinander angebrachte und ebenso ausgerichtete Module über sehr kurze Anschlussleitungen verbunden werden können wie in Figur 8 zu erkennen ist. Dies spart Material (Kabel) und reduziert gleichzeitig die elektrischen Verluste in den Kabeln.
Die am meisten verbreiteten kristallinen PV-Module beinhalten üblicherweise 6 Reihen von Zellen, wobei in einer Reihe typischerweise 6 ... 16 Zellen (in den meisten
Fällen 10 ... 12 Zellen) in Serie verschaltet sind. Möchte man jetzt 6 Zellreihen in der üblichen Weise Mäanderförmig und seriell verschalten und dabei die Forderung nach horizontalen Busbars erfüllen, würde der Strompfad innerhalb des Moduls ausgehend von links in der ersten Reihe nach rechts gehen und in der zweiten Reihe wieder
nach links zurück. Nach der 6 Reihe würde der Strompfad auf der linken Seite enden, was weit weg von der rechts angebrachten J-Box ist, und einen zusätzlichen Verdrahtungsaufwand bedeutet und zusätzliche elektrische Verluste bedeutet. Diese ungünstige Verschaltung (in Verbindung mit den horizontal verlaufenden Busbars und vertikalen Versteifungen) ist in Fig. 6 dargestellt.
Um die Verdrahtung innerhalb des Moduls zu optimieren werden in Fig. 5 jeweils 2 Reihen von Zellen elektrisch parallel geschaltet. Das bedeutet, dass ausgehend von der linken J-Box der Strompfad über zwei elektrisch parallel verschaltete Zellreihen nach rechts verläuft, und von dort wieder über zwei parallele Zellreihen nach links verläuft und sodann wieder über 2 parallele Zellreichen nach rechts in die Nähe der rechten J-Box verläuft. Damit ist es möglich die Verdrahtung innerhalb des Moduls kurz zu halten und das Modul auf zwei horizontal gegenüberliegenden Seiten (rechts und links) jeweils mit dem daran anschließenden Modul auf sehr kurzem Weg zu verbinden.
Das Ziel die Anschlussdosen rechts und links, bei gleichzeitig optimierter elektrischer Verdrahtung innerhalb des Moduls kann man auch erreichen, wenn sich in dem Modul wie in Fig. 7 gezeigt fünf seriell verschalteten Zellreihen befinden. Die Zahl von fünf Zellreihen ist beispielhaft für eine ungerade Zahl von Zellreichen zu verstehen. Das gleiche Ziel kann auch erreicht werden, wenn in dem Modul 2 Reihen von Zellen parallel geschaltet werden und das Modul 6 oder 10 (allgemein das doppelte einer ungeraden Zahl (2*(2N+1)) Reihen von Zellen beinhaltet.
Ebenso kann das Ziel erreicht werden, wenn im Modul 3 Reihen von Zellen parallel geschaltet sind und das Modul 9 oder 15 (allgemein das dreifache einer ungeraden Zahl (2*(2N+1)) Reihen von Zellen beinhaltet.
Fig. 8 zeigt eine die Verschaltung von Modul zu Modul, die durch die getrennten Anschlussdosen möglich ist, wobei man besonders kurze Anschlussleitungen erreichen kann. Die Anschlussdosen müssen nicht am Rand des Moduls angebracht sein und müssen nicht (wie man nach den Figuren vermuten könnte) über den Rand des Glases hinausstehen. Die Dosen können ebenso in der Nähe des rechten und linken Randes des Moduls angebracht sein.

Prinzipiell ist es möglich, die vorteilhafte Verschaltung von nebeneinander liegenden Modulen auch mit der gebräuchlichen meanderförmigen Verschaltung der Zellreihen zu erreichen. Eine mögliche Lösung ist in Fig. 9 gezeigt. Abgesehen davon, dass hier die Busbars der Zelle nicht horizontal liegen, gibt es hier deutliche Nachteile im Verhalten bei teilweiser Verschattung.
Diese sind:
- Wenn beispielsweise nur die unterste Zeile mit 6 Zellen verschattet ist, bricht die Leistung, die das Modul liefern kann in der Regel vollkommen zusammen. Dieser Fall der Verschattung tritt in einer typischen Freiflächen Installation mit mehreren Reihen von Modultischen regelmäßig ein.
- Wenn Schnee auf den Modulen liegt, kommt es häufig vor, dass das Modul schon zu 80% von Schnee befreit ist, aber die unterste Reihe der Zellen noch verschattet ist. Damit bricht auch hier die Performance des Moduls ein.

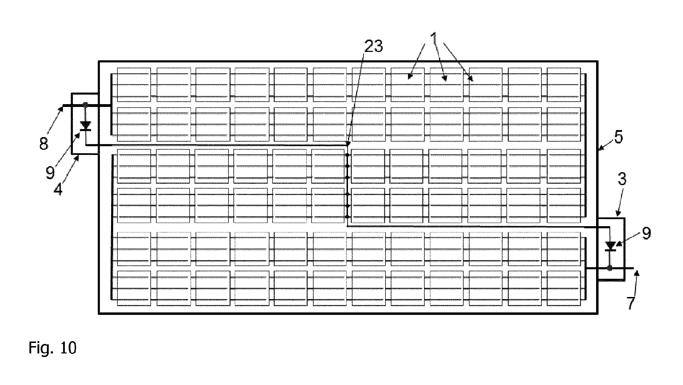

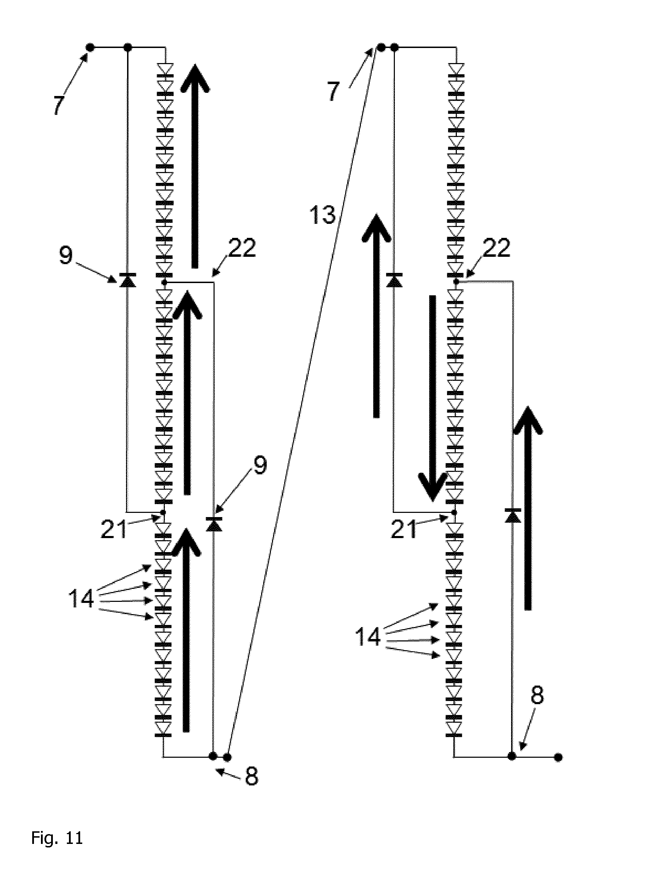

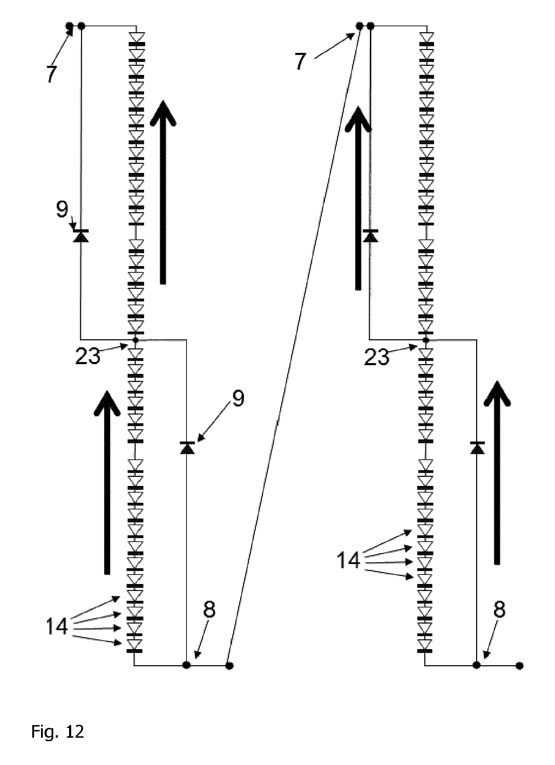

Die Bypassdioden verhindern, dass es bei den Zellen, denen sie parallel geschaltet sind zu "Hot-Spots" kommt. Derartige "Hot-Spots" können entstehen, wenn über einzelnen Zellen infolge Verschattung vergleichsweise hohe Sperrspannungen (z. B. 20 V) auftreten und es lokal zu einem Durchbruch eines pn-Übergangs einer Solarzelle kommt.
Durch die Bypass-Dioden wird die Sperrspannung, die sich über einer Zelle aufbauen kann begrenzt. Für die Vermeidung von Hot-Spots ist es erforderlich, dass parallel zu einem Bereich seriell verschalteter Zellen eine Bypassdiode geschaltet ist und dass jede Zelle in einem Modul mindestens zu einem seriell verschaltetem Bereich mit paralleler Bypassdiode gehört.
Eine zweite Aufgabe der Bypassdioden ist, dass Sie so weit wie möglichst den Verlust reduzieren, der durch ein (teil-)verschattetes Modul entsteht, das seriell in einem stärker bestrahlten String verschaltet ist.
Dieser Effekt wird in Figur 12 erläutert. Hierbei ist das vereinfachte Schaltbild für das Modul nach Figur 10 aufgezeichnet. Dieses Modul besitzt 72 Zellen, wobei hier zwei Teil-Strings von jeweils 36 seriell verschalteten Zellen parallel geschaltet sind. Aus diesem Grund sind in Figur 12 pro Modul nur 36 Solarzellen 14 gezeichnet Das Modul besitzt einen Mittelabgriff 23, der jeweils nach 18 seriell verschalteten Zellen eine elektrische Verbindung zwischen den parallel geschalteten Teilstrings herstellt und zu den Bypassdioden herausgeführt ist. Am Mittelabgriff ist je eine Bypassdiode zum Pluspol und zum Minuspol so angeschlossen dass diese Dioden im normalen Betrieb in Sperrrichtung betrieben werden. In Figur 12 ist nun das Schaltbild für einen String von zwei seriell verschalteten Modulen nach Figur 10 gezeichnet, wobei das linke Modul voll bestrahlt ist und das rechte Modul unbestrahlt ist. Dicke Strompfeile veranschaulichen den Stromfluss im Modul. Bei dem bestrahlten Modul fließt der gesamte Strom über die Zellen vom Minuspol 8 zum Pluspol 7. Im Gegensatz dazu fließt im unbestrahlten Modul der gesamte Strom über die Bypassdioden, wobei über den Dioden ein parasitärer Spannungsabfall von ca. 1 V pro Diode auftritt, wodurch die Leistung des gesamten Strings etwas reduziert wird. Es gibt hier einen direkten Strompfad durch die Bypassdioden zwischen Plus und Minuspol des Moduls.
Die Fertigung des Moduls nach Figur 10 wird erschwert, da der Mittelabgriff 23 eigens verdrahtet werden muss. Dies ist ein zusätzlicher Fertigungsschritt, der bei den heute üblichen Modulen nicht benötigt wird und daher mit zusätzlichem Aufwand verbunden ist.
Der wesentliche Unterschied zwischen dem Modul von Figur 10 und dem Modul von Figur 5 liegt in der Verschaltung der Bypassdioden. Auch bei Figur 5 sind 36 Zellpaare seriell verschaltet, ebenso werden 2 Bypassdioden verwendet, die jedoch nicht mehr am Mittelabriff angeschlossen sind. Das dazugehörige vereinfachte Schaltbild ist in Figur 11 zu sehen. Die erste Bypassdiode liegt zwischen Minus-Pol 8 und dem Abgriff 22 nach 24 Zellpaaren gezählt vom Minus Pol ausgehend. Die zweite Bypassdiode liegt zwischen dem Abgriff 21 nach dem 12 Zellpaaren vom Minuspol aus gezählt und dem Pluspool 7 (also nach weiteren 24 Zellpaaren nach dem 12 Zellpaar). Die Bypassdioden sind wieder so gepolt, dass sie im normalen Betrieb des Solarmoduls in Sperrrichtung betrieben sind. Der Vorteil dieser Verschaltung liegt darin, dass dies besonders einfach zu fertigen ist, da die hierfür erforderlichen Abgriffe geometrisch sehr günstig liegen, da die dazugehörigen Zellen bei Meanderförmiger verschaltung in unmittelbarer Nachbarschaft zueinander liegen. Dies kann auch beim Vergleich von Figur 5 mit Figur 10 leicht erkannt werden. Bei dieser Schaltung gibt es keinen direkten Strompfad zwischen Pluspol und Minuspol über eine Serienschaltung mehrerer direkt verbundener Bypassdioden. Der Strom muss im Falle der Verschattung teilweise über Solarzellen fließen.
Dem Vorteil der einfachen Fertigung steht als Nachteil die schlechtere Verschattungsperformance gegenüber.
Diese soll in Figur 11 veranschaulicht werden. Hier ist das vereinfachte Schaltbild für einen String von zwei seriell verschalteten Modulen nach Figur 5 gezeichnet, wobei das linke Modul voll bestrahlt ist und das rechte Modul unbestrahlt ist. Dicke Strompfeile veranschaulichen den Stromfluss im Modul. Bei dem bestrahlten Modul fließt der gesamte Strom über die Zellen vom Minuspol zum Pluspol. Im Gegensatz dazu fließt im unbestrahlten Modul (links) der Strom vom Minus-Pol 8 über die erste Bypassdiode zum Knoten 22, von dort aus über die zwischen Konten 22 und Knoten 21 liegenden 12 Zellpaare, die für diesen Strom in Flusspolung geschaltet sind und dann weiter über die zweite Bypassdiode des unbestrahlten Moduls zum Pluspol. In diesem Fall kommt es im unbestrahlten Modul zu einem Spannungsabfall durch die beiden Bypassdioden (in Summe ca. 2 V) dem aber noch der Spannungsabfall über 12 in Flusspolung geschaltete unbeleuchtete Paare von Solarzellen hinzugerechnet werden muss. Insgesamt ergibt sich ein parasitärer Spannungsabfall der in der Größenordnung 5 - 10 V liegt. Dies stellt einen wesentlichen Verlust dar, da das voll bestrahlte Modul im MPP betrieben nur eine Spannung von etwa 15 -20 V liefert. Damit hat ein unbestrahltes Solarmodul, bei dem es keinen direkten Strompfad zwischen Plus- und Minuspol über die Bypassdioden gibt, deutlich höhere elektrische Verluste als ein unbestrahltes Solarmodul, bei dem einen direkten Strompfad zwischen Pluspol und Minuspol über die Bypassdioden gibt.

Im Folgenden soll die Verschaltung einer Vielzahl von Modulen gezeigt werden, bei der der eben dargestellte Nachteil der schlechten Verschattungsperformance der indirekt verschalteten Bypassdioden so gut wie nicht zum Tragen kommt, da hier die Module so verschaltet werden, dass in einem String alle Module einen nahezu gleichartige Bestrahlung erhalten.
Um verschiedene Verschaltungsmöglichkeiten in einem PV-Kraftwerk zu vergleichen wird beispielhaft im Folgenden angenommen, dass es sich um eine große Freiflächeninstallation handelt, von der zwei Tischreihen betrachtet werden. Die Tischreihen sind geneigt in Richtung zum Äquator (nach Süden auf der nördlichen Hemisphäre). Jede Tischreihe beinhaltet eine untere Modulzeile (diese ist die, die näher am Sonnensymbol gezeichnet ist) und eine obere Modulzeile.

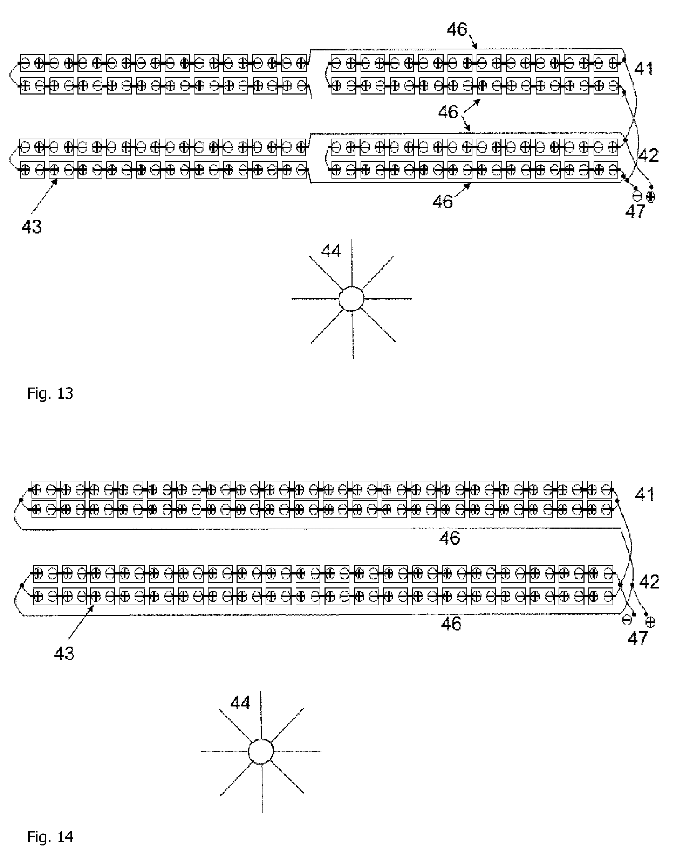

In Figur 13 ist zunächst einmal eine erste übliche Verschaltung von vier Modulstrings gezeichnet. Hierbei wird beispielhaft angenommen, dass in einem String 20 Module in Serie geschaltet sind. Weiterhin wird angenommen, dass die Zellen innerhalb eines Moduls seriell verschaltet sind wie dies zum Beispiel in Figur 6 veranschaulicht. Die Strings in Figur 13 sind so verschaltet, dass von den 20 seriell verschalteten Modulen jeweils 10 Module in der unteren Modulzeile einer Tischreihe sind, und 10 in der oberen Modulzeile einer Tischreihe sind.
Kommt es bei dieser Verschaltung zu einer Verschattung beispielsweise der unteren Modulzeile, dann sind in den verschatteten Modulen die Bypassdioden aktiv sodass der Strom der in der oberen Modulzeile erzeugt wird nur mit einem relativ geringen Spannungsabfall über die Bypassdioden der unteren Modulzeile zum Stromabnehmer (z. B. Wechselrichter) geleitet wird, der an 47 angeschlossen ist. Im beschriebenen verschatteten Zustand ist die Spannung die der Modulstring an 47 abgibt nur etwa die Hälfte der Spannung des voll bestrahlten Modulstrings. Dies bedeutet, dass der Wechselrichter einen sehr weiten Eingangsspannungsbereich aufweisen muss um auch im verschatteten Zustand noch eine gute Ernte zu erzielen. Wenn man hier ein Modul verwendet, bei dem die Bypassdioden keinen direkten Pfad zwischen Pluspol und Minuspol des Moduls bilden muss hier mit großen zusätzlichen Verlusten gerechnet werden.

In Figur 14 ist eine zweite gebräuchliche Verschaltung gezeigt mit der gleichen Art von Modulen (z. B. wie Figur 6), bei der ein kompletter String immer in der gleichen Modulzeile liegt. Von den vier Strings liegen in jeder der beiden Tischreihen jeweils ein kompletter String in der unteren Modulzeile und einer in der oberen Modulzeile. Wenn hier die untere Modulzeile verschattet wird liefert sie keinen (genauer gesagt deutlich weniger) Strom, während der Strom von der oberen Modulzeile zum Stromabnehmer geleitet wird. Über die Bypassdioden der unteren Modulzeile fließt kein wesentlicher Strom. In diesem Fall können ohne wesentliche elektrische Verluste auch Module eingesetzt werden bei denen die Bypassdioden keinen direkten Pfad zwischen Pluspol und Minuspol bilden. An den Stromabnehmer der an 47 angeschlossen ist wird wenn nur die obere Modulzeile bestrahlt wird, nahezu die gleiche Spannung wie im voll bestrahlten Zustand geliefert (jedoch nur der halbe Strom). Im Vergleich zur ersten gebräuchlichen Verschaltung ist hier von Vorteil, dass ein an 47 angeschlossener Wechselrichter oder Stromabnehmer nur einen wesentlich geringeren Eingangsspannungsbereich haben muss, was Kosten sparen kann.

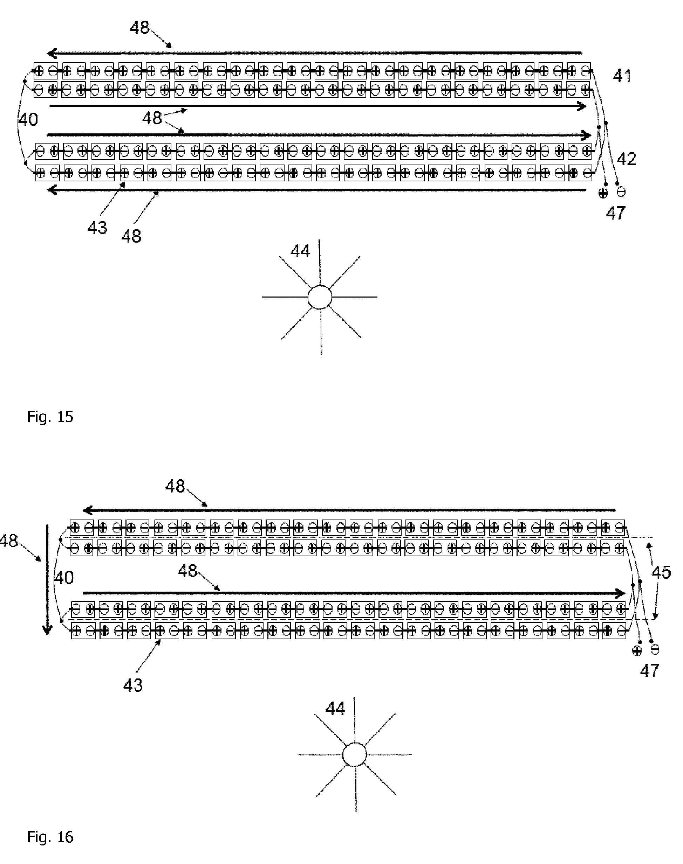

In Figur 15 ist eine neuartige erfindungsgemäße vorteilhafte Verschaltung gezeigt, bei der im Vergleich zu den bisherigen Schaltungen weniger Verdrahtungsaufwand zum Anschluss der Module an einen Stromabnehmer 47 erforderlich ist. Innerhalb jedes Moduls werden zwei Strings parallel verschaltet, wie dies beispielsweise auch bei dem Modul in Figur 5 (oder Figur 10) der Fall ist.
Damit liefert jedes Modul die halbe Spannung und den doppelten Strom im Vergleich zu den Modulen von Figur 13 und 14. Wenn ein String die gleiche Spannung erzeugen soll wie in den letzten Beispielen, dann beinhaltet ein String jetzt 40 Module statt 20 Module. Für die Installation werden jetzt nur noch 2 Strings jeweils einer pro Tischreihe benötigt. Diese beiden Strings werden in der unteren Modulzeile beispielsweise nach Westen geleitet und ändern nach dem 20ten Modul die Richtung nach Osten, so dass das letzte Modul des Strings wieder sehr nahe dem ursprünglichen Ausgangspunkt ist. Als Besonderheit kommt hinzu, dass in der ersten Tischreihe (näher an der Sonne) der String in der unteren Modulzeile mit dem Minuspol beginnt, und in der oberen Modulzeile mit dem Pluspol endet. In der zweiten Tischreihe (weiter von der Sonnen entfernen) beginnt der String in der oberen Modulzeile mit dem Minus-Pol und endet in der unteren Modulzeile mit dem Pluspol. Nach jeweils dem 20ten Modul beinhalten beide Strings einen Mittelabgriff und die Mittelabgriffe beider Strings werden miteinander verbunden über die elektrische Verbindungsleitung 40. Wenn das Modulfeld vollständig bestrahlt ist, dann fließt der Strom entsprechend der dicken Pfeile in Figur 15 durch die Module. Sämtliche Module tragen zur Stromerzeugung bei. Durch die Verbindung 40, die die beiden Mittelabgriffe der Modulstrings verbindet, gibt es keinen wesentlichen Stromfluss, da der Aufbau weitgehend symmetrisch ist und man annehmen kann, dass alle Module etwas gleich viel Strom, Spannung und Energie erzeugen.
Wird nun wie in Figur 16 bei den beiden Tischreihen jeweils die untere Modulzeile verschattet (dies wird in Figur 16 durch die Verschattungsgrenze 45 angedeutet) dann wird in der unteren Modulzeile (so gut wie) kein Strom mehr erzeugt. Damit kommt der Verbindung 40 der Mittelabgriffe der Modulstrings eine besondere Bedeutung zu. Der überwiegende Stromfluss ist jetzt Folgender. Ausgehend vom Minuspol des Stromabnehmers 47 fließt der Strom über den Minuspol der zweiten Tischreihe (weiter weg von der Sonne) in der oberen Modulzeile (Stromfluss wird veranschaulicht durch Pfeil 48) und fließt dann über die Verbindung der Mittelabgriffe (40) in die erste Tischreihe und dort wieder in der bestrahlten oberen Modulzeile zum Pluspol der ersten Tischreihe (näher an der Sonne (d. h. kann zweite Tischreihe verschatten) wo er abgenommen werden kann. Im Vergleich zur den gebräuchlichen Installationen von Figur 13 und 14 wird hierfür nur ein Bruchteil der Kabellänge benötigt um die Module zu verschalten.
Damit auch im Verschattungsfall der Strom zum Stromabnehmer 47 fließen kann muss der Strom nicht über Bypassdioden fließen. Das Modul braucht demnach nicht Bypassdioden, die einen direkten Pfad zwischen Pluspol und Minuspol bilden.
Die Spannung am Stromabnehmer 47 ist im dargestellten teilverschatteten Zustand nahezu die gleiche wie im voll bestrahlten Zustand, wodurch geringe Anforderungen an den Eingangsspannungsbereich des Stromabnehmers gestellt werden.

Damit vereinigt diese Schaltung eine Reihe von Vorzügen:
- sehr geringer Verdrahtungsbedarf
- sehr gute Ernte auch bei teilweiser Verschattung
- geringe Anforderungen an Eingangsspannungsbereich des Wechselrichters
- Modul ohne direkten Pfad von Bypassdioden zwischen Plus und Minus kann verwendet werden.
- geringe Induktion bei Blitzen (wegen kleiner vom Strompfad umschlossener Fläche und Symmetrie des Aufbaus)

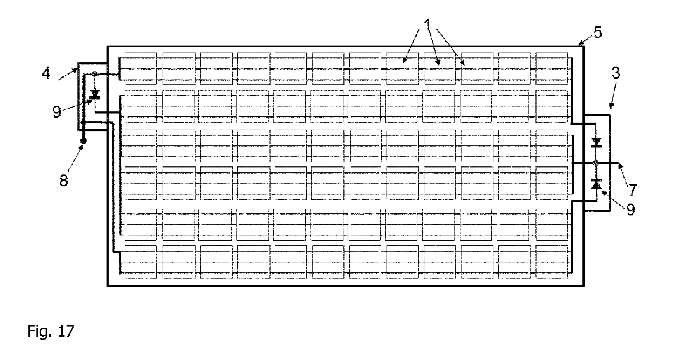

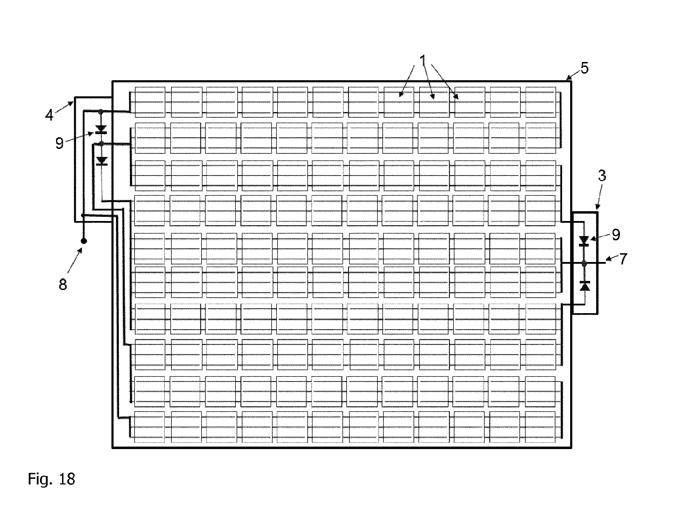

In Figur 17 ist das Modul von Figur 10 weiter für den beschriebenen Einsatz optimiert. Die beiden Zellstrings im Modul sind so angeordnet, dass wenn die untere Hälfte des Moduls verschattet ist, das Modul noch die Hälfte des Stroms erzeugt. Dazu ist einer der Zellstrings vollständig in der oberen Hälfte des Moduls angeordnet und der zweite Zellstring vollständig in der unteren Hälfte des Moduls angeordnet. In Figur 18 ist eine mögliche Realisierung der Erfindung gezeigt, bei der das Modul zwei elektrisch parallel geschaltete Strings mit jeweils 5 Zellreihen besitzt. Auch hier sind die Zellen so verschaltet, dass das Modul noch die halbe Leistung liefern kann, wenn die unteres Hälfte des Moduls verschattet ist. Bei Verwendung von Wafer Zellen mit 156 mm Kantenlänge hat diese Modul etwa das Format 1,65m x 2,0 m. Werden dafür 126 mm Zellen verwendet hat dieses Modul etwa das Format 1,35 m x 1,6 m.
In Figur 18 ist eine mögliche Realisierung der Erfindung gezeigt, bei der das Modul drei elektrisch parallel geschaltete Strings mit jeweils 3 Zellreihen besitzt. Hier sind die Zellen so verschaltet, dass der erste String sich im unteren Drittel des Moduls befindet, und der zweite String im mittleren Drittel und der Dritte String im oberen Drittel sich befinden. Dadurch kann das Modul noch zwei Drittel der Leistung liefern wenn vom Modul weniger als das untere (bzw. das obere) Drittel verschattet ist und noch ein Drittel der Leistung wenn das oberste (bzw. unterste) Drittel des Moduls unverschattet ist.

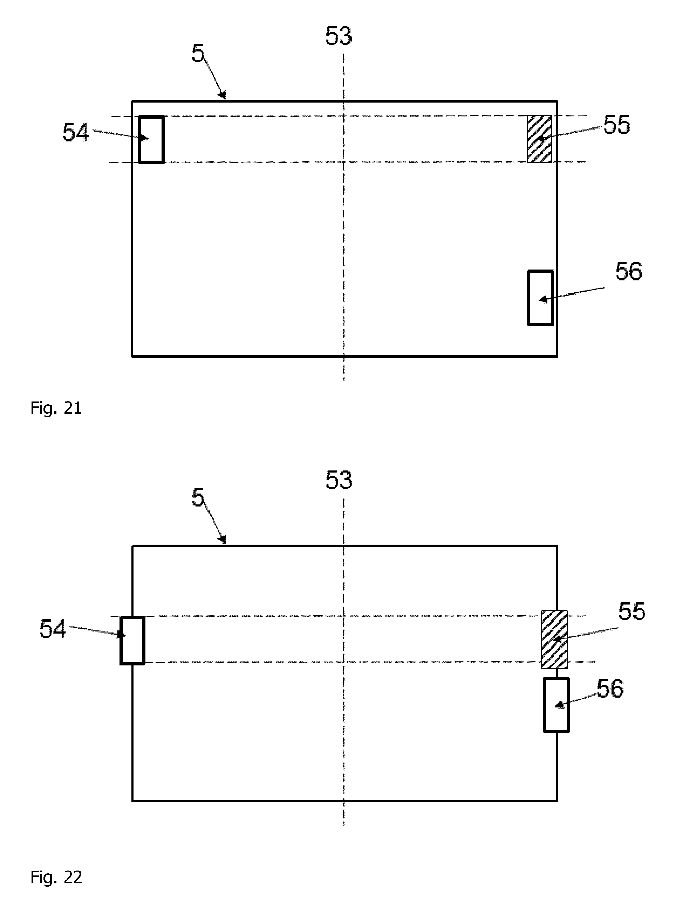

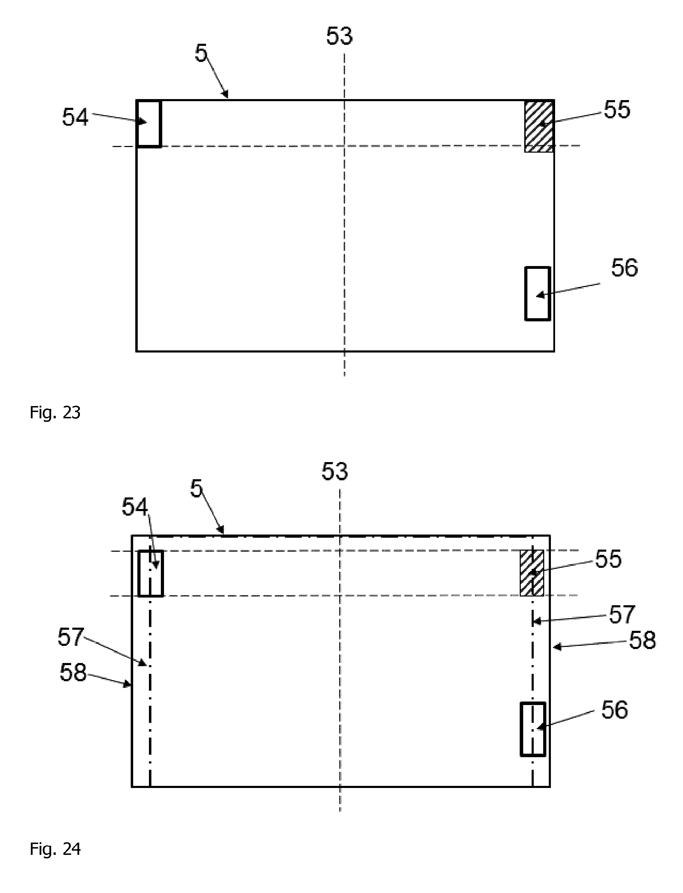

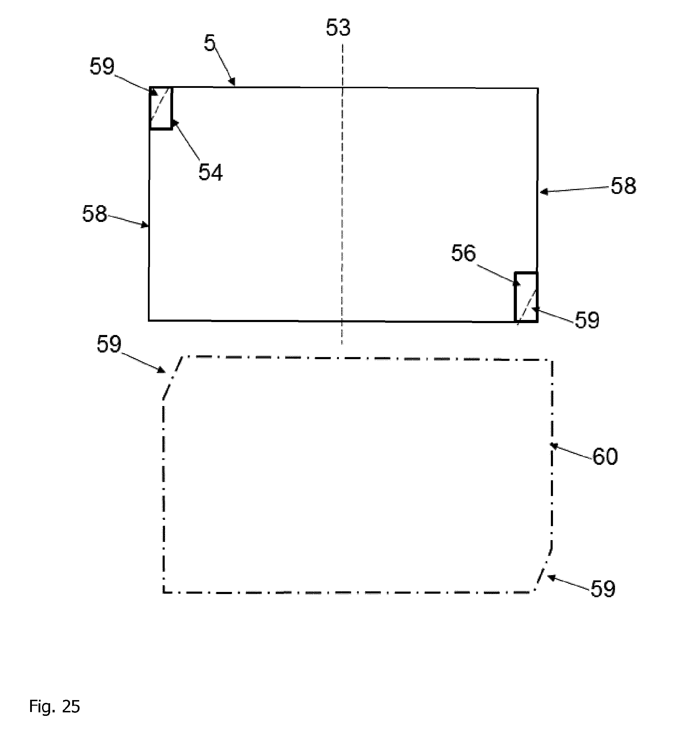

Bezüglich der Platzierung der elektrischen Anschlussdosen wurden folgende vorteilhafte Realisierungen gefunden.
- die Anschlussdosen des Moduls können in der Nähe des linken und rechten Randes vollständig auf der Rückseite des Moduls und vollständig innerhalb der Ränder (links, rechts, oben, unten) des Moduls angebracht werden wie es in Fig. 21 gezeigt ist. Sie können aber auch ganz oder teilweise über den Rand des Moduls hinausragen (Fig 22). Um die Lage der Anschlussdosen am Modul zu bestimmen, wird zunächst die linke Dose 54 in der Nähe des linken Modulrands platziert. Der Bereich den die linke Dose einnimmt wird dann an der Mittelachse zwischen rechtem und linkem Modulrand gespiegelt (und etwas (ca. 1..2 cm) in alle Richtungen vergrößert) wodurch in der Nähe des rechten Modulrandes der verbotene Bereich 55 definiert wird, in dem die rechte Moduldose nicht liegen darf. Die rechte Moduldose 56 wird sodann in der Nähe des rechten Rands außerhalb des verbotenen Bereichs platziert, wobei darauf zu achten ist, dass zwei nebeneinander liegende Module möglichst leicht elektrisch verbunden werden können. Durch diese Vorschrift ist sichergestellt, dass jeweils 2 Module Rückseite an Rückseite gelegt werden können wobei es nicht zu Zusammenstoßen der Anschlussdosen kommt, und daher die Module sehr platzsparend gelagert und transportiert werden können.
- Eine oder beide Dosen können dabei auch im Bereich der Ecken des Moduls platziert sein wie in siehe Fig. 23 zu erkennen.
- Bei Glas-Glas Modulen wurde als vorteilhaft gefunden, wenn die Anschlussdosen so am Rand des Moduls platziert werden, dass das Rückglas nicht gebohrt werden muss. Hierzu kann beispielsweise ein Rückglas (Rand des Rückglases 57) verwendet werden, das in rechts - links Ausdehnung etwas kleiner ist als das Frontglas (Rand des Frontglases 58). Die Anschlussdosen können dann ganz oder teilweise in dem Bereich liegen, in dem das Frontglas über das Rückglas hinausragt (Fig. 24), wodurch elektrische Verbindungen von den Zellen zur Dose geführt werden können ohne dass das Rückglas gebohrt werden muss. Zusätzlich ist bei diesem Aufbau sichergestellt, dass die Anschlussdose leicht auf der Rückseite des Moduls so angebracht werden kann, dass sie insbesondere vor Umweltenflüssen (Regen, Schnee, UV-Strahlung) gut geschützt ist.
- Als besonders vorteilhaft wurde gefunden, wenn bei einem (rechteckigen) Glas-Glas Modul beim Rückglas an zwei diagonal gegenüber liegenden Ecken die Ecken gekappt werden. Im Bereich einer gekappten Ecke kann (können) die elektrische(n) Verbindung(en) von den Zellen zu den nahe der entsprechenden Ecke liegenden Anschlussdose geführt werden. Dadurch ergibt sich wiederum der Vorteil, dass das Rückglas nicht gebohrt werden muss. Zusätzlich verursachen die in der Ecke angebrachten Dosen einen sehr geringen Platzbedarf relativ zur Modulfläche. Zusätzlich kann eine an der Ecke angebrachte Dose auch leicht einen guten Kantenschutz für das Modul darstellen. Fig. 25 zeigt ein entsprechend aufgebautes Modul wobei im unteren Teil von Fig. 25 zusätzlich das Rückglas 60 mit den gekappten Ecken 59 zu Veranschaulichung dargestellt ist.

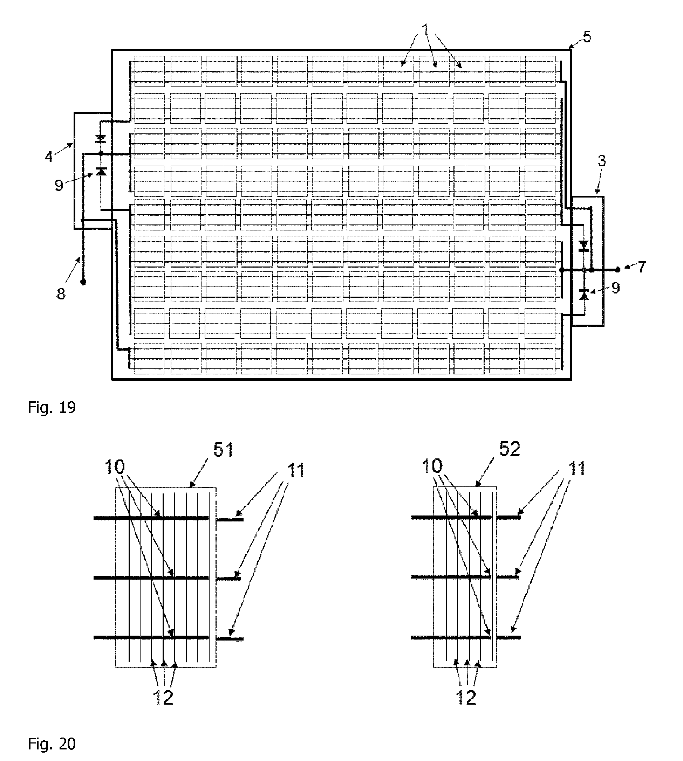

Im Folgenden werden für Solarmodule, die aus Teilzellen (in der Regel Halb-Zellen bzw. Drittel-Zellen) aufgebaut sind Verschaltungskonzepte vorgestellt, die als besonders vorteilhaft gefundenen wurden. Die Teilzellen sind typischerweise rechteckig (wenn die Teilzellen nicht aus quadratischen Zellen hergestellt werden, sondern aus pseudoquadratischen Zellen, dann sind die Teilzellen zumindest nahezu rechteckig), wobei die rechteckigen Zellen jeweils zwei kurze und zwei lange Seiten haben, und die kurze Seite typischerweise die Hälfte bzw. ein Drittel der langen Seite ist wie es in Fig. 20 zu sehen ist.
Die Busbars und damit der Stromfluss durch die Zellen verlaufen parallel zu den kurzen Seiten des Rechtecks (siehe Fig. 20). Der Aufbau der aus Teilzellen aufgebauten Module berücksichtigt folgende Regeln:
- Es werden geteilte elektrische Anschlussdosen (J-Box) verwendet, wobei sich eine Dose in der Nähe des linken Rands des Moduls befindet und eine Dose in der Nähe des rechten Rands des Moduls.
- Der Strom durch das Modul mit Teilzellen soll mindestens dem Strom einer "Vollzelle" entsprechen. Dies kann dadurch erreicht werden, dass in den Modulen mit Teil-Zellen mindestens 2 Teilstrings aus Halb-Zellen parallel geschaltet werden.
- Der Strom durch das Modul soll bevorzugt das 1,5 ... 4 fache des Stroms einer einzelnen "Voll-Zelle betragen. Dadurch ist die Spannung eines einzelnen Moduls etwa um diesen Faktor geringer und man kann bei gegebener Systemspannung um diesen Faktor mehr Module zu einem String verschalten, wodurch - wie vorher beschrieben - sich Vorteile bei der Verdrahtung von großen Solarparks ergeben können. Der 1,5 ... 4 fache Strom an den Modulanschlüssen kann erreicht werden durch Parallelschaltung von 3 ... 8 Teil-Strings (Teil-String innerhalb eines Moduls) aus Halb-Zellen (bzw. 4 ... 12 Teilstrings aus Drittel-Zellen)
- Im optimalen Fall ist der Strom durch das Modul das 2 ... 3 fache des Stromes einer "Voll-Zelle", was durch Parallelschalten von 4 ... 6 Teil-Strings aus seriell verschalteten Halb-Zellen (oder 6 ... 9 Drittel-Zellen) erreicht werden kann.
- Die Module werden bevorzugt in Landscape - Ausrichtung montiert. Dies ist keine notwendige Bedingung, jedoch bringt die Landscape Ausrichtung der Module Vorteile bei der Verschattung, da die Modulleistung in kleineren Portionen ausfällt. Obendrein wird bei einem Modul in Landscape ein größerer Transportweg (von der linken zur rechten Moduldose) für den Strom möglich so dass außerhalb des Moduls ein geringerer Verdrahtungsaufwand anfällt.
- Die Versteifungsstrukturen auf der Rückseite oder am Rand des Moduls verlaufen senkrecht zu den Busbars.

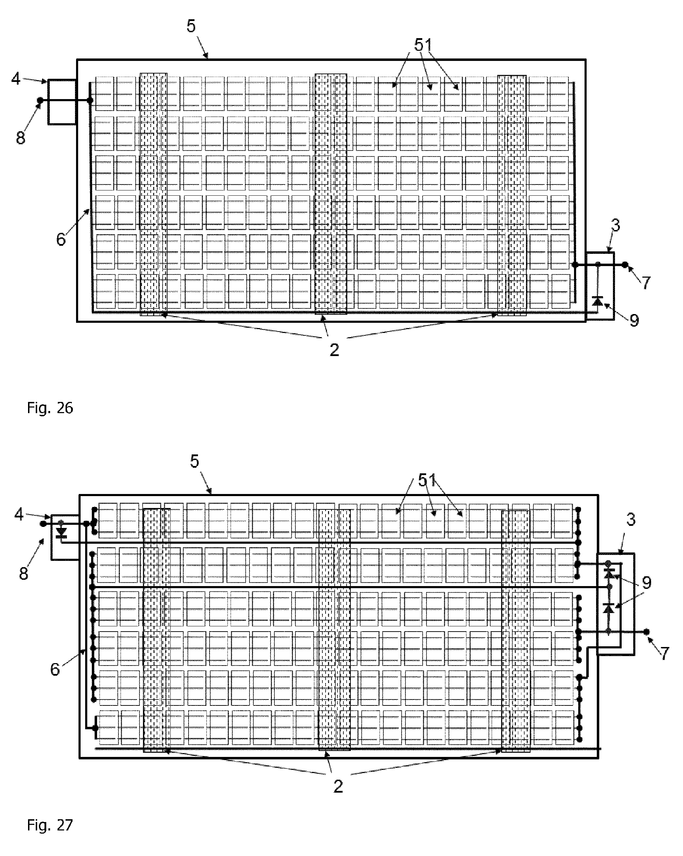

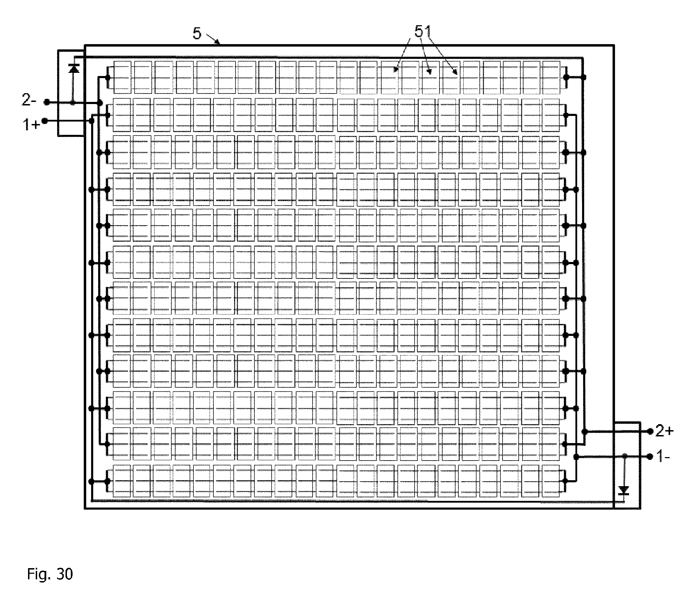

Im Folgenden werden beispielhaft einige als vorteilhaft gefundene Modulformate und Zellverschaltungen gezeigt. In Fig. 26 ist ein Modul mit 6 horizontalen Zell-Reihen gezeigt, bei dem jede Zellreihe einen Teilstring aus seriell verschalteten Halbzellen bildet und diese 6 Teilstrings wiederum parallel geschaltet sind. Typischerweise können bis zu 24 Zellen seriell verschaltet werden, wobei diese Serienschaltung dann mit einer Bypassdiode versehen werden sollte. In einer der beiden Anschlussdosen kann die hierfür erforderliche Bypassdiode untergebracht werden, die in Sperrrichtung zwischen Minus-Pol und Plus-Pol des PV-Moduls angebracht ist. Dieses Modul liefert etwa den dreifachen Strom eines typischen kristallinen Moduls mit ganzen Zellen die einfach seriell verschaltet sind. Das Modul mit 6 Zellreihen muss natürlich nicht zwangsläufig von links nach rechts 24 seriell verschaltete Zellen haben. Die Zahl 24 ist nur beispielhaft, es kann auch eine geringere oder eine größere Zahl sein. Würden bei einem, dem soeben beschriebenen vergleichbar aufgebautem Modul Drittel-Zellen verwendet werden, so würde das Modul mit 6 Zellreihen den doppelten Strom eines üblichen Moduls mit ganzen Zellen liefern.
Eine andere Alternative für die Verschaltung eines Moduls mit 6 Zellreihen ist in Fig 27 zu sehen. Hierbei werden zwei Teilstrings mit seriell verschalteten Halb-Zellen parallel geschaltet, so dass das Modul etwa den gleichen Strom liefert wie ein Modul mit ganzen Zellen. Auch hier sind wiederum Bypassdioden vorgesehen, die in gewohnter Weise einer Serienschaltung von in diesem Fall wiederum 24 Halbzellen parallel geschaltet ist.
Vergleichbar den soeben gezeigten Beispielen kann auch ein Modul aus 9 Zellreihen aufgebaut werden, bei dem 3 Teilstrings aus Halb-Zellen parallel geschaltet sind. Diese Modul würde einen Strom liefern, der etwa 1,5 mal so groß ist wie der Strom eines üblichen Moduls mit ganzen Zellen.
Bei den versteifenden Strukturen auf der Rückseite des Moduls sollte berücksichtigt werden, dass diese eine platzsparende Lagerung (und damit auch einen kostengünstigen Transport ermöglichen).

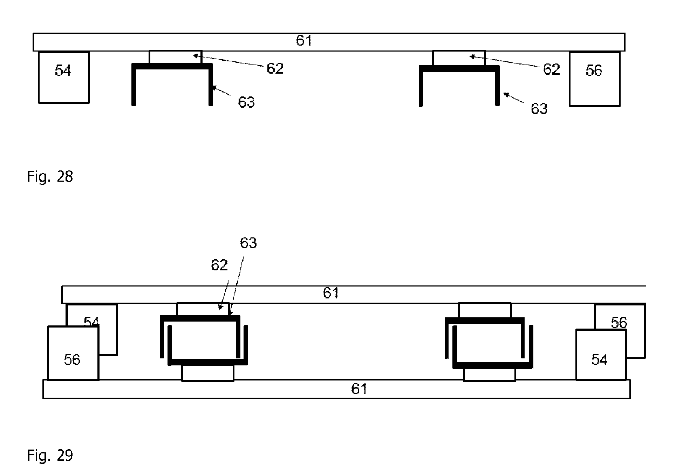

Fig. 28 zeigt ein PV-Modul 61 (Draufsicht auf Modulkante) bei dem auf der Rückseite mit Klebstoff 62 Backrails 63 aufgeklebt sind. Am linken und rechten Rand des Moduls kann man die Anschlussdosen erkennen, die maximal ebenso weit nach hinten ragen wie die U-förmigen nach hinten offenen Backrails (zuzüglich der Blechstärke des Backrails und der Dicke des Klebstoffes.
Zwei derartige Module können nun sehr platzsparend Rückseite an Rückseite gelagert und transportiert werden, da die nach hinten offen U-förmigen Backrails etwas gegeneinander versetzt platzsparend ineinander geschoben werden können wie es in Fig 29 zu sehen ist.
Da die Anschlussdosen am linken und rechte Rand gegeneinander versetzt sind kommt es auch nicht zu einer Kollision der Anschlussdosen.
Als eine Weiterbildung der Erfindung wird ein Doppel-Modul offenbart, das aus zwei elektrisch voneinander isolierten Teilmodulen besteht, wobei das eine Teilmodul auf der linken Seite den Plus-Pol (1+) und auf der rechten Seite den Minus-Pol (1-) hat, während das zweite Teilmodul auf der rechten Seite den Pluspol (2+) und auf der linken Seite den Minuspol (2-) hat. Dieses Doppelmodul kann vorteilhaft für vorher beschriebenen Verschaltung von Solarparks eingesetzt werden für zwei benachbarte in verschiedenen Modulzeilen liegende Module, wie sie beispielsweis in Fig. 13 und Fig. 15 vorkommen. Um die Verschattungsperformance weiter zu verbessern, können die Zellreihen so verschachtelt werden, dass im Falle einer Verschattung möglichst beide Teilmodule gleich betroffen sind. In Fig. 30 ist ein derartiges Doppel-Modul gezeigt. Hierbei sind 12 Zellreihen aus Halb-Zellen vorhanden, von denen 6 Zellreihen zu einen Teilmodul und 6 Zellreihen zum anderen Modul gehören. Wenn die Zellreihen von unten nach oben durchgezählt werden gehören die geradzahligen Zellreihen zum Teilmodul 1 und die ungeradzahligen zum Teilmodul 2. Zusätzlich ist für jedes Teilmodul eine Bypassdiode vorhanden.

## Patentansprüche

1. PV-Modul mit kristallinen Zellen mit Busbars wobei der mechanische Stress, der zu Microcracks in den Zellen führen kann möglichst vermieden wird durch aussteifende Strukturen, die auf der Rückseite des Moduls angebracht sind, und die senkrecht zu den Busbars der Zellen verlaufen.

2. PV-Modul mit kristallinen Zellen nach Anspruch 1 **dadurch gekennzeichnet dass** die aussteifenden Strukturen auch zum Befestigen des PV-Moduls ausgebildet sind.

3. PV-Modul mit kristallinen Zellen nach Anspruch 1 oder 2 **dadurch gekennzeichnet, dass** das Modul mit einer Anschlussdose für Plus und mit einer Anschlussdose für Minus versehen ist, wobei bei Draufsicht auf die Modul-Vorderseite eines senkrecht stehenden Moduls eine Anschlussdosen auf der rechten und eine auf der linken Seite angebracht sind, und die Busbars der Zellen in horizontaler Richtung verlaufen und die aussteifenden Strukturen von oben nach unten verlaufen.

4. PV-Modul mit kristallinen Zellen nach Anspruch 3 **dadurch gekennzeichnet, dass** die Zellen im Modul meanderfrömig verschaltet werden.

5. PV-Modul mit kristallinen Zellen nach Anspruch 3 oder 4 **dadurch gekennzeichnet, dass** im Modul 5, 7 oder 9 Zellreihen mit jeweils 6 ... 18 Zellen verschaltet sind.

6. PV-Modul mit kristallinen Zellen nach Anspruch 3 oder 4 **dadurch gekennzeichnet, dass** im Modul jeweils 2 Zellreihen parallel geschaltet sind, wobei das Modul insgesamt 6, 10 oder 14 Zellreihen beinhaltet.

7. PV-Modul mit kristallinen Zellen nach Anspruch 3 oder 4 **dadurch gekennzeichnet, dass** das im Modul jeweils 3 Zellreihen parallel geschaltet sind, wobei das Modul 9, 15 oder 21 Zellreihen beinhaltet.

8. PV-Modul mit kristallinen Zellen nach Anspruch 3 ... 7 **dadurch gekennzeichnet, dass** innerhalb eines Moduls mehrfach, parallel zu einem Bereich serielle verschalteter Zellen eine Bypassdiode geschaltet ist, und dass jede Zelle in dem Modul mindestens zu einem seriell verschaltetem Bereich mit paralleler Bypassdiode gehört, wobei es im Modul keinen direkten Strompfad zwischen dem Pluspol und Minuspol des Moduls über eine Serienschaltung mehrerer direkt verbundener Bypassdioden gibt.

9. PV-Modul mit kristallinen Zellen nach Anspruch 3 ... 8 **dadurch gekennzeichnet**, in dem Modul rechteckige Halb-Zellen verwendet werden, wie sie durch Teilen von quadratischen Zellen hergestellt werden können indem die Zellen senkrecht zu den Busbars geschnitten werden und in zwei gleich große rechteckige Halb-Zellen geteilt werden.

10. PV-Modul mit kristallinen Zellen nach Anspruch 9 **dadurch gekennzeichnet, dass** das Modul 6 Zellreihen beinhaltet, die alle parallel geschaltet sind.

11. PV-Modul mit kristallinen Zellen nach Anspruch 3 ... 9 **dadurch gekennzeichnet** das es sich um eine Doppelmodul handelt, das zwei elektrisch isolierte Teilmodule enthält mit zusammen vier elektrischen Anschlüssen, wobei das erste Teilmodul links den Pluspol und rechts den Minuspol hat und das zweite Teilmodul den Pluspol rechts und den Minuspol links hat.

12. Verschaltung von einer Vielzahl von Modulen nach einem der Ansprüche 3, 4, 5, 6, 7, 8, 9, 10 oder 11 **dadurch gekennzeichnet, dass** daraus zwei seriell verschaltete Modul-Strings aufgebaut werden, die elektrisch parallel geschaltet sind und die in zwei verschiedenen Tischreihen eingebaut sind und die beiden Strings nach der Hälfte der Module je einen elektrischen Mittelabgriff besitzen und die Mittelabgriffe der beiden Modulstrings elektrisch miteinander verbunden sind.
